# EUROPÄISCHE PATENTSCHRIFT

(11) **EP 3 918 116 B1**
(45) Veröffentlichungstag und Bekanntmachung des Hinweises auf die Patenterteilung: **07.06.2023**
(21) Anmeldenummer: 20708424.5
(22) Anmeldetag: 24.01.2020
(51) Int. Cl.: C30B 15/14, C30B 15/20, C30B 15/30, C30B 29/06

(54) **VERFAHREN ZUM ZIEHEN EINES ZYLINDRISCHEN KRISTALLS AUS EINER SCHMELZE**
METHOD FOR PULLING A CYLINDRICAL CRYSTAL FROM A MELT
PROCÉDÉ POUR LE TIRAGE D'UN CRISTAL CYLINDRIQUE À PARTIR D'UNE MASSE FONDUE

(30) Priorität: 28.01.2019 DE 102019101991
(43) Veröffentlichungstag der Anmeldung: 08.12.2021
(73) Patentinhaber: PVA TePla AG, 35435 Wettenberg (DE)
(72) Erfinder: MÜHE, Andreas, 35576 Wetzlar (DE)
(74) Vertreter: Rauch, Udo
(86) Internationale Anmeldenummer: PCT/DE2020/200007
(87) Internationale Veröffentlichungsnummer: WO 2020/156621

(56) Entgegenhaltungen:
- KR-A- 20150 089 718
- US-A1- 2013 263 773

## Beschreibung

Die Erfindung bezieht sich auf ein Verfahren zum Ziehen eines zylindrischen Kristalls aus einer Schmelze mittels einer Kristallziehanlage, die aufweist: Einen Tiegel, in dem sich die Schmelze befindet, einen Tiegelheizer, der den Tiegel ringförmig umgibt, eine Tiegelhubeinrichtung zum Heben des Tiegels, eine Kristallhubeinrichtung zum Ziehen des Kristalls aus der Schmelze und einen den Kristall ringförmig umgebenden Hitzeschild, dessen untere Kante unter Bildung eines Ringspaltes oberhalb der Schmelze endet.

Bei der Kristallzüchtung nach dem Czochralski-Verfahren wird ein Kristall aus einer heißen Schmelze gezogen, wobei die Atome der Schmelze sich an der unteren Stirnseite des Kristalls in einer für das Material der Schmelze typischen Gitterstruktur anlegen, so dass bei einem langsamen Herausziehen des Kristalls aus der Schmelze, bei dem er abkühlt, ein starres Kristallgitter erzeugt wird. In der schmelzennahen Schicht des Kristalls sind zunächst noch intrinsische Punktdefekte, nämlich Leerstellen, das sind unbesetzte Gitterplätze, und Zwischengitteratome, das sind Atome zwischen den Gitterplätzen, vorhanden, welche sich aber, wenn der Ziehvorgang mit geeigneten Parametern durchgeführt wird, paarweise annihilieren, so dass sich ein homogenes und weitgehend fehlstellenfreies Kristallgitter ausbildet. Diese Form der Kristallzüchtung wird z. B. verwendet, um Siliziumkristalle herzustellen, die für die Halbleiterindustrie benötigt werden. Dazu werden von dem Kristall dünne Scheiben, sogenannte Wafer, abgeschnitten, aus denen integrierte Schaltkreise hergestellt werden.

Generell soll ein Ziehvorgang so gestaltet werden, dass der gezogene Kristall einen möglichst gleichbleibenden Durchmesser aufweist und durch eine möglichst vollständige Annihilation der intrinsischen Punktdefekte eine hohe Homogenität aufweist.

Aus der DE 10 2013 210 687 A1 ist ein Verfahren zur Regelung des Durchmessers eines Kristalls beschrieben, bei dem der Durchmesser des Kristalls an der Schmelzenoberfläche direkt oder indirekt bestimmt wird und mit einem gewünschten Solldurchmesser verglichen wird. Daraus wird eine geeignete Kristallziehgeschwindigkeit als Stellgröße für die Kristallhubeinrichtung abgeleitet, so dass sich der gewünschte Kristalldurchmesser einstellt. Weitere Beispiele für konventionelle Durchmesserregelungen finden sich in der WO 01/57294 A1 und US 2011/0126757 A1.

Dabei ist die Kristallziehgeschwindigkeit die relative Geschwindigkeit des Kristalls, mit der dieser sich relativ zur Schmelzenoberfläche bewegt. Da diese üblicherweise auf einen konstant hohen absoluten Level der Schmelzenoberfläche in Bezug zur Kristallziehanlage eingestellt wird, entspricht die Kristallziehgeschwindigkeit der absoluten Kristallhubgeschwindigkeit, also der Geschwindigkeit des Kristalls gegenüber den ortsfesten Teilen der Kristallziehanlage.

Die Kristallziehgeschwindigkeit hat aber auch Einfluss auf die Homogenität des Kristalls. Die oben erwähnte Heilung der intrinsischen Punktdefekte wird bewirkt, indem die an der Stirnseite des Kristalls noch vorliegenden intrinsischen Punktdefekte sich in den unteren, schmelznahen Schichten des Kristalls gegenseitig kompensieren, indem die Zwischengitteratome in die Leerstellen wandern. Da die Diffusionsgeschwindigkeiten der Zwischengitteratome und der Leerstellen unterschiedlich sind, kann eine nahezu vollständige Kompensation nur dann erreicht werden, wenn die Kristallziehgeschwindigkeit in einem bestimmten Verhältnis zum vertikalen Temperaturgradienten im Kristall steht. Da der Temperaturgradient material- und anlagenspezifisch ist, verändert sich bei einer Durchmesserregelung, die die Kristallziehgeschwindigkeit als Stellgröße nutzt, das Verhältnis von Kristallziehgeschwindigkeit zum vertikalen Temperaturgradienten im gleichen Maße wie die Kristallziehgeschwindigkeit, so dass das Verhältnis nicht immer einen Wert aufweist, der notwendig ist, um einen möglichst homogenen Kristall zu erhalten. Eine solche Homogenität wird aber von Produzenten von integrierten Schaltkreisen gefordert, um ihren Produktionsausschuss gering zu halten.

In der Steuerung des Silizium-Czochralski-Prozesses gibt es zwei charakteristische Zeitskalen:
(A) Die Zeitskala von Minuten bis einige 10 Minuten, auf der die Fluktuationen der Schmelzkonvektion ablaufen. Durch die thermisch instabile Schichtung der Schmelze in der Czochralski-Anordnung gibt es eine typische, nichtstationäre und oft sogar turbulente Schmelzkonvektion, die den Wärme- und Stofftransport durch die Schmelze maßgeblich beeinflusst. Als Folge fluktuiert die Temperatur an der Wachstumsfront des Kristalls, was in der Praxis zu willkürlichen Durchmesserschwankungen auf der Längenskala von Millimetern führt.
(B) Die Zeitskala von Stunden bis einige 10 Stunden, auf der sich der Schmelzpegel durch die kontinuierliche Entnahme von Silizium durch den wachsenden Kristall ändert, ausgehend von einem fast vollen Tiegel bei Prozessbeginn bis hin zu einem fast leeren Tiegel bei Prozessende. Durch diese kontinuierliche Änderung des Schmelzpegels ändert sich die makroskopische Geometrie der Züchtungsanordnung, insbesondere die Tiegelposition relativ zum Hauptheizer und Bodenheizer, aber auch das Verhältnis von freier Schmelzoberfläche zu benetzter Tiegelwandfläche.

Um einerseits den Kristalldurchmesser, andererseits die Kristallqualität - hier insbesondere die Sauerstoff-Konzentration und die Konzentration von Punktdefekten - gezielt einstellen zu können, werden im Stand der Technik immer mindestens 2 Regelkreise eingesetzt, wobei ein Regelkreis mit einem ersten Regler auf der Zeitskala (A) arbeitet und somit überwiegend Einflüsse der Schmelzkonvektion kompensiert, während ein zweiter Regelkreis mit einem zweiten Regler auf der Zeitskala (B) arbeitet und somit überwiegend Einflüsse der Änderung des Schmelzpegels im Tiegel kompensiert.

Der erste Regler passt die Kristallziehgeschwindigkeit an, während der zweite Regler die Leistung des Tiegelheizers einstellt.

Da die Regelung des Kristalldurchmessers nach dem Stand der Technik mittels der Anpassung der Kristallziehgeschwindigkeit erfolgt und diese dadurch einer ständigen Änderung unterworfen ist, kann die Homogenität des gezogenen Kristalls nicht optimal sein.

Die Erfindung beruht daher auf der Aufgabe, einen Regelalgorithmus für einen Kristallziehvorgang darzustellen, der einen homogenen und möglichst fehlstellenfreien Kristall mit einem möglichst gleichbleibenden Durchmesser liefert.

Zur Lösung der Aufgabe sieht die Erfindung vor, dass der Istwert des Kristalldurchmessers an der Schmelzenoberfläche gemessen und mit einem Sollwert für den Kristalldurchmesser verglichen wird und dass die Höhe des Ringspaltes in Abhängigkeit von der Abweichung zwischen dem Ist- und dem Sollwert mit einem ersten Regler, der eine erste Nachstellzeit aufweist, eingestellt wird,
dass die Höhe des Ringspaltes in Abhängigkeit von der Abweichung zwischen dem Ist- und dem Sollwert mit einem ersten Regler, der eine erste Nachstellzeit aufweist, eingestellt wird, wobei bei einem Istwert, der kleiner ist als der Sollwert, die Ringspalthöhe verkleinert und bei einem Istwert, der größer ist als der Sollwert, die Ringspalthöhe vergrößert wird, und
dass zur Änderung der Ringspalthöhe die Hubgeschwindigkeit des Tiegels und im gleichen Maße die Hubgeschwindigkeit des Kristalls variiert werden, so dass die Kristallziehgeschwindigkeit konstant bleibt.

Im Stand der Technik (EP 2 659 031 B1 oder US 6,458,203 B1) wird zwar allgemein auf die Bedeutung des Ringspaltes verwiesen, nicht aber explizit ausgesagt, seine Höhe unter Beibehaltung der Kristallziehgeschwindigkeit so zu beeinflussen, dass der Kristalldurchmesser auf einen konstanten Wert geregelt wird.

Zum Stand der Technik sind auch die KR 2015 0089718 A und die US 2013/263773 A1 zu nennen. Beide Dokumente offenbaren eine Regelung der Ringspalthöhe, mit der diese auf einen konstanten Wert eingestellt wird.

Die Temperatur des Kristalls an seiner Mantelfläche unmittelbar oberhalb der Schmelzenoberfläche hat sowohl einen wesentlichen Einfluss auf Homogenität des Kristalls als auch auf den sich ausbildenden Durchmesser. Wenn somit durch geeignete Maßnahmen erreicht werden kann, dass in diesem unteren Bereich der Mantelfläche keine Wärmeabstrahlung erfolgt, ist der vertikale Temperaturgradient über den Durchmesser des Kristalls gleichmäßig, so dass bei einer geeigneten Kristallziehgeschwindigkeit über den gesamten Durchmesser des Kristalls ein optimaler Wert für das Verhältnis von Kristallziehgeschwindigkeit und Temperaturgradient vorliegt, der eine nahezu vollständige Rekombination von Gitterleerstellen und Zwischengitteratomen ermöglicht.

Des Weiteren hat sich gezeigt, dass bei einer verstärkten seitlichen Wärmeabstrahlung der Randbereich des Kristalls abkühlt und dieser sich damit weitet bzw. bei einer Wärmeeinstrahlung in den Kristall sich dieser zusammenzieht. Da sich bei einer Vergrößerung des Ringspaltes die Wärmeleistung erhöht, die durch Strahlung auf die untere Kristallmantelfläche trifft, wird die Oberflächentemperatur der Kristallmantelfläche erhöht und damit der von der Phasengrenze wegführend vertikale Temperaturgradient/Wärmefluss im Kristall verringert. Somit kann weniger latente Wärme von der Phasengrenze abfließen, was bei gleicher Ziehgeschwindigkeit zu einem abnehmenden Kristalldurchmesser führt.

Dieser Einfluss der Wärmeein- bzw. -ausstrahlung auf die Homogenität des Kristalls wird auch schon in der DE 10 2013 210 687 A1 angesprochen. Um diese beeinflussen zu können, ist zusätzlich zum Tiegelheizer ein Ringheizer unmittelbar am Kristall vorgesehen. Dieser kann ebenfalls zur Regelung des Durchmessers des Kristalls verwendet werden, indem die Stellgröße der Regelung auf die Beeinflussung der elektrischen Leistung dieses Ringheizers gerichtet ist. Diese Vorgehensweise hat aber den Nachteil, dass ein zusätzlicher Ringheizer benötigt wird, der sich darüber hinaus an einer hitzeexponierten Stelle befindet und daher besonders ausfallgefährdet ist.

Die Erfindung sieht daher vor, dass nicht ein zusätzlicher Ringheizer genutzt wird, sondern die Wärmeabstrahlung des an sich vorhandenen Tiegelheizers genutzt wird, der dazu dient, die Schmelze auf einer bestimmten Temperatur zu halten. Die Wärmeabstrahlung des Tiegelheizers trifft nämlich durch den Ringspalt hindurch die untere Mantelfläche des Kristalls, so dass die Wärmeeinstrahlung auf den Kristall bzw. dessen Wärmeabstrahlung durch eine Änderung der Ringspalthöhe reguliert werden kann. Auf eine gesonderte Ringheizung kann somit verzichtet werden.

Vorzugsweis wird die erste Nachstellzeit so gewählt, dass Einflüsse der Schmelzkonvektion an der die Schmelze kontaktierenden Stirnfläche des Kristalls und der Schmelze kompensiert werden. Es findet somit eine Anpassung der Ringspalthöhe in der Zeitskala (A) statt.

Der weitere Vorteil dieser Regelung besteht darin, dass die Kristallziehgeschwindigkeit, also die Geschwindigkeit, mit der der Kristall relativ zur Schmelzenoberfläche bewegt wird, konstant gehalten wird. Dazu werden die Hubgeschwindigkeit des Tiegels, der den Volumenverlust der Schmelze berücksichtigt, und die Hubgeschwindigkeit des Kristalls jeweils in Relation zur Anlage im gleichen Maße verändert, wodurch sich zwar nicht die Kristallziehgeschwindigkeit, wohl aber der Abstand der Schmelzenoberfläche zur unteren Kante des Hitzeschildes und damit die Höhe des Ringspaltes ändert.

Die Reglung erzeugt dazu einen Stellwert für die Ringspalthöhe. Dazu wird eine Offset-Geschwindigkeit bestimmt. Diese wird sowohl zu einem Grundwert für die Hubgeschwindigkeit des Tiegels, die benötigt wird, um den Volumenverbrauch der Schmelze zu kompensieren, als auch zu einem Grundwert für die Geschwindigkeit des Kristallhubs, die der gewünschten Kristallziehgeschwindigkeit bei einem konstanten Level der Schmelzenoberfläche entspricht, hinzu addiert. Je nachdem, ob die Ringspalthöhe vergrößert oder verkleinert werden soll, ist der Offsetwert positiv oder negativ.

Da beide Geschwindigkeiten im gleichen Maße geändert werden, bleibt die Kristallziehgeschwindigkeit unbeeinflusst. Geändert wird allerdings die Ringspalthöhe, so dass sich die Schmelzenoberfläche durch die geänderte Tiegelhubgeschwindigkeit dem unteren Rand des Hitzeschildes nähert bzw. sich von ihm entfernt.

Diese innere Regelung wird auch überlagert von einer äußeren Regelung, die auf die Heizleistung des Tiegelheizers zielt. Daher sieht die Erfindung vor, dass der Stellwert für die Ringspalthöhe als Istwert für eine Regelung der Heizleistung des Tiegelheizers mittels eines zweiten Reglers, der eine zweite Nachstellzeit aufweist, zugeführt wird, wobei eine mittlere Ringspalthöhe als Sollwert vorgegeben wird.

Dabei wird die zweite Nachstellzeit so gewählt, dass Einflüsse der sich während des Ziehvorganges einstellenden Änderungen der Lage der Schmelzenoberfläche im Tiegel kompensiert werden. Die Regelung findet somit auf der Zeitskala (B) statt.

Dies bedeutet, dass die erste Nachstellzeit kleiner ist als die zweite Nachstellzeit.

In der äußeren Regelung wird der zeitlich gemittelte Stellwert für die Ringspalthöhe als Istwert dem Heizleistungssteller zugeführt. Dies wird vorzugsweise dadurch erreicht, dass der Stellwert über einen PT1-Filter dem Heizleistungssteller als modifizierter Stellwert zugeführt wird.

Im Folgenden soll anhand eines Ausführungsbeispiels die Erfindung näher erläutert werden. Dazu zeigen:
- Fig. 1: eine schematische Darstellung einer Kristallziehanlage nach den Czochralskiverfahren,
- Fig. 2: ein Regelschema nach dem Stand der Technik,
- Fig. 3: ein Regelschema gemäß der Erfindung und

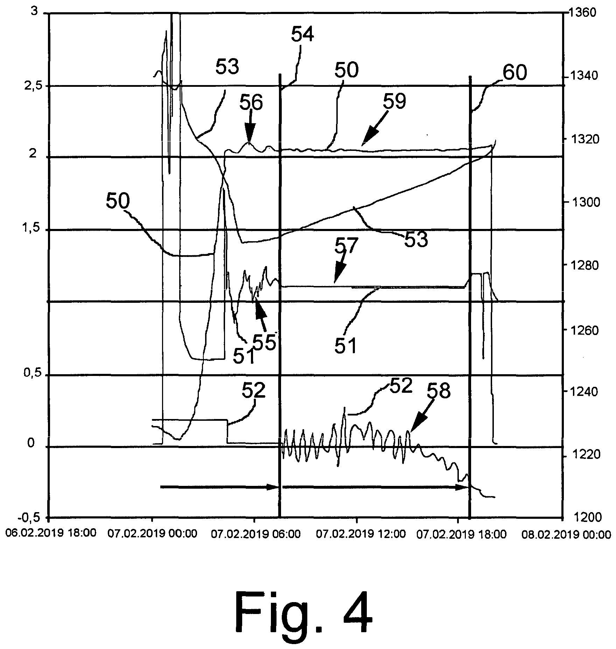

- Fig. 4: ein Protokoll eines Kristallziehvorganges in Diagrammform.

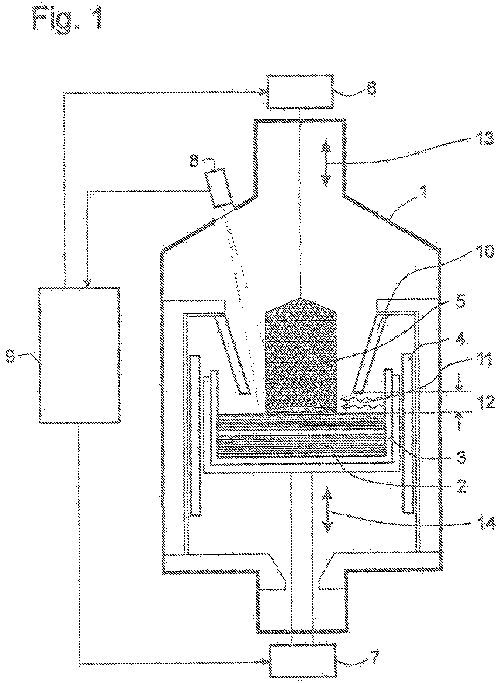

Zunächst wird auf die Fig. 1 Bezug genommen. Gemäß der Fig. 1 besteht die Kristallziehanlage aus einem Anlagengehäuse 1, in dem sich ein mit einer Schmelze 2 gefüllter Tiegel 3 befindet. Um den Tiegel herum befindet sich ein Tiegelheizer 4, mit dessen Hilfe das Material im Tiegel 3 eingeschmolzen und anschließend auf Temperatur gehalten wird.

Ein zylinderförmiger Kristall 5 wird mittels einer Kristallhubeinrichtung 6 langsam aus der Schmelze 2 gezogen, wobei sich die Atome der Schmelze 2 an die untere Stirnseite des Kristalls 5 anlegen und beim Herausziehen des Kristalls aus der Schmelze 2 ein Kristallgitter bilden. Dabei wird Material im Tiegel 3 verbraucht, so dass Kristallziehanlagen üblicherweise eine Tiegelhubeinrichtung 7 vorsehen, mit der der Tiegel 3 nachgeführt wird, so dass sich die Schmelzenoberfläche stets auf einem konstanten Level im Bezug zum Anlagengehäuse 1 befindet.

Der Kristalldurchmesser wird mittels einer Kamera 8 erfasst, die auf den Rand des Kristalls im Übergang zur Schmelze gerichtet ist. Aus den von der Kamera 8 gewonnenen Bildern kann der Kristalldurchmesser abgeleitet werden. Die dafür eingesetzten Bildauswertungsverfahren sind dem Fachmann bekannt und brauchen daher hier nicht näher erläutert werden.

Der Kristallziehvorgang wird mittels einer Steuereinrichtung 9 geregelt. Diese enthält Informationen von der Kamera 8 und sendet Stellgrößen an die Kristallhubeinrichtung 6 und an die Tiegelhubeinrichtung 7.

Damit der aus der Schmelze gezogene Kristall nach und nach abkühlen kann, ist ein den Kristall umgebender Hitzeschild 10 notwendig, der die Abstrahlung des Tiegelheizers 4 sowie der heißen Schmelze vom oberen Bereich der Mantelfläche des Kristalls 5 fernhält.

Die untere Kante des Hitzeschildes 10 endet oberhalb der Oberfläche der Schmelze 2, so dass ein Ringspalt 12 zwischen der Kante des Hitzeschildes 10 und der Schmelze vorliegt. Durch diesen Ringspalt 12 erfolgt eine Wärmeeinstrahlung auf den unteren Bereich der Mantelfläche des Kristalls 5.

Für die Steuerung des Ziehvorganges sind die folgenden Größen zu beachten: Entscheidend ist letztendlich die Kristallziehgeschwindigkeit, das ist die Geschwindigkeit des Kristalls relativ zur Schmelzenoberfläche. Diese wird bestimmt von der absoluten Hubgeschwindigkeit 13 des Kristalls, das ist die Geschwindigkeit, mit der der Kristall gegenüber der Anlage bewegt wird, und der Geschwindigkeit der Schmelzenoberfläche relativ zur Anlage. Wenn diese auf Null gestellt ist, die Schmelzenoberfläche somit auf einem konstanten Level in Bezug zur Anlage gehalten wird, entspricht die Kristallziehgeschwindigkeit der der absoluten Hubgeschwindigkeit 13 des Kristalls.

Die Geschwindigkeit der Schmelzenoberfläche im Bezug zur Anlage wird bestimmt durch die absolute Hubgeschwindigkeit 14 des Tiegels unter Berücksichtigung der Absenkung der Schmelzenoberfläche innerhalb des Tiegels aufgrund des Materialverbrauchs. Die Hubgeschwindigkeit des Tiegels lässt sich z. B. dadurch bestimmen, dass die Materialaufnahme des Kristalls 5 an Hand der Kristallziehgeschwindigkeit ermittelt wird, so dass das Absenken der Schmelzenoberfläche im Bezug zum Tiegel 3 durch einen entsprechenden Hub des Tiegels 3 kompensiert wird, so dass die Schmelzenoberfläche auf einem konstanten Level im Bezug zur Anlage verbleibt.

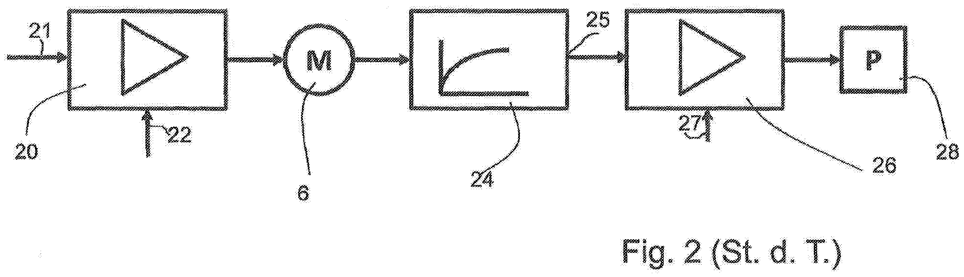

In der Fig. 2 ist ein Regelschema dargestellt, mit dem nach dem Stand der Technik ein Kristallziehvorgang geregelt wird, um einen möglichst konstanten Durchmesser des Kristalls zu erreichen. Dieser besteht aus einem Durchmesserregler 20, der an einem ersten Eingang 21 einen Durchmesser-Istwert und an einem zweiten Eingang 22 einen Durchmesser-Sollwert erhält. Am Ausgang 23 des Durchmesserreglers 20 wird ein Stellwert für die Kristallhubeinrichtung 6 ausgegeben.

Um eine zu große Drift der Kristallziehgeschwindigkeit zu verhindern, wird der Stellwert auch einem PT1-Filter 24 zugeführt, dessen Ausgang 25 einen Regler 26 für eine mittlere Kristallziehgeschwindigkeit als Istwert zugeführt wird. Dazu liegt an einem Eingang 27 ein Sollwert für die mittlere Kristallziehgeschwindigkeit an. Durch einen Vergleich von Ist- und Sollwert wird ein Stellwert für die Heizleistung des Tiegelheizers 4 generiert, der einem Heizleistungssteller 28 zugeführt wird.

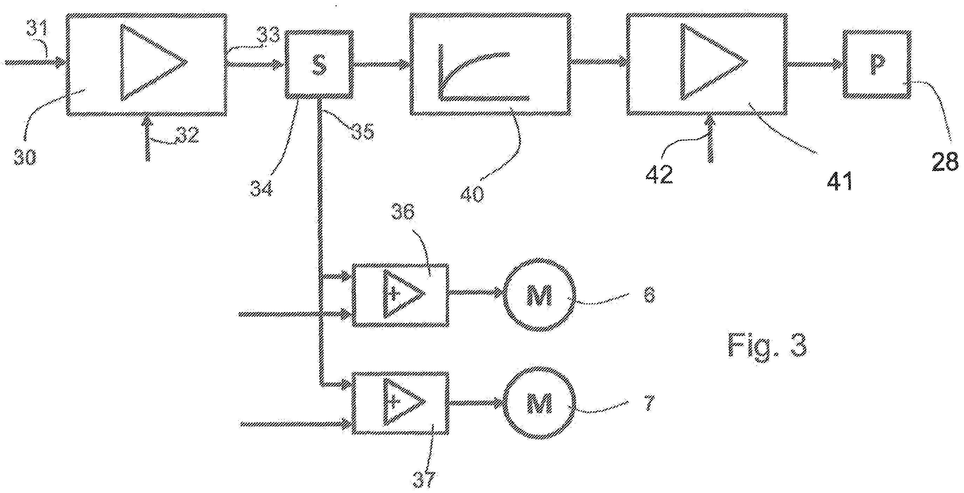

Im Gegensatz dazu besteht gemäß der Fig. 3 das erfindungsgemäße Regelschema aus einem Durchmesserregler 30, dem an einem ersten Eingang 31 ein Istwert für den Kristalldurchmesser und an einem zweiten Eingang 32 ein Sollwert für den Kristalldurchmesser zugeführt wird. Vom Durchmesserregler 30 wird am Ausgang 33 ein Stellwert für die Ringspalthöhe generiert, der einem Ringspalthöhensteller 34 zur Verfügung gestellt wird.

Dieser generiert einen Offsetwert an seinem Ausgang 35, der sowohl einem Kristallhubsteller 36 als auch einem Tiegelhubsteller 37 zugeführt wird. In den Stellern 36, 37 wird der Offsetwert zu einem Grundwert für die Tiegelhubgeschwindigkeit 14 bzw. einem Grundwert für Kristallhubgeschwindigkeit 13 hinzuaddiert, so dass sich die Kristallhubgeschwindigkeit 13 und die Tiegelhubgeschwindigkeit 14 im gleichen Maße ändern, ohne dass sich die Kristallziehgeschwindigkeit ändern würde. Der Tiegelhubgrundwert ist der Wert, mit dem die Schmelzenoberfläche unter Berücksichtigung des Verbrauchs auf einem konstanten Level gehalten wird. Der Kristallhubgrundwert ist der Wert der gewünschten Kristallziehgeschwindigkeit.

Entscheidend für die Erfindung ist somit, dass sich zwar die Kristallhubgeschwindigkeit 13 ändert, nicht aber die Kristallziehgeschwindigkeit, mit der sich der Kristall 5 aus der Schmelze 2 erhebt. Dabei ändert der Tiegel 3 seine Lage so, dass sich die Schmelzenoberfläche in Bezug zur Unterkante des Hitzeschildes 10 verlagert, wodurch sich die Höhe des Ringspaltes 12 ändert. Die Wärmeeinstrahlung vom Tiegelheizer 4 in die untere Mantelfläche des Kristalls kann damit auf einem Wert gehalten werden, bei dem zumindest im unteren Bereich des Kristalls keine Wärmeabstrahlung vorliegt, so dass bei konstanter Kristallziehgeschwindigkeit ein gleichbleibender Durchmesser des Kristalls 5 und ein optimales Verhältnis von Temperaturgradient zu Kristallziehgeschwindigkeit erzielt wird.

Auch hier wird dem inneren Regelkreis ein langsamer äußerer Regelkreis überlagert. Der Stellwert für den Spalthöhensteller wird über einem PT1-Filter 40 einem Regler 41 für die mittlere Ringspalthöhe zugeführt. Dieser Wert wird mit einem Sollwert am Eingang 42 für die mittlere Ringspalthöhe verglichen und daraus resultierend ein entsprechender Stellwert für den Heizleistungsteller 28 zur Verfügung gestellt. Da der PT1-Filter 40 den für den Heizleistungsteller 28 relevanten Istwert proportional zur zeitlichen Änderung des Stellwertes für den Ringspalthöhensteller 34 ändert, ergibt sich ein verlangsamter Regelvorgang für den äußeren Regelkreis.

Das Diagramm zeigt über mehrere Stunden den zeitlichen Verlauf des Kristalldurchmesser-Istwertes (Kurve 50), gemessen mit einer Kamera, der Kristallziehgeschwindigkeit (Kurve 51), der Höhe des Ringspaltes (Kurve 52) und der Tempertaur des Tiegelheizers (Kurve 53).

In der ersten Phase des Züchtungsversuchs - dargestellt bis zur ersten Zeitlinie 54 - wird der Kristalldurchmesser mit einer konventionellen Reglerkaskade über die Ziehgeschwindigkeit im inneren Regelkreis und die Temperatur des Hauptheizers im äußeren Regelkreis geregelt. Man erkennt deutlich die Schwankungen der Ziehgeschwindigkeit (Hinweispfeil 55) auf der Zeitskala (A), die mit einer deutlichen Änderung des Kristalldurchmessers einhergehen (Hinweispfeil 56).

Anschließend (ab der ersten Zeitlinie 54) ist die Steuerung der Kristallziehanlage auf die erfindungsgemäße Regelung umgeschaltet worden, bei der im inneren Regelkreis die Ringspalthöhe und im äußeren Regelkreis weiterhin die Temperatur des Hauptheizers als Stellgröße verwendet wird. Man erkennt, dass nach der Umschaltung die Ziehgeschwindigkeit völlig konstant gehalten wurde (Hinweispfeil 57), während nun die Ringspalthöhe auf der Zeitskala (A) schwankt (Hinweispfeil 58). Bei dieser Regelung wird ein wesentlich gleichbleibender Kristalldurchmesser erreicht (Hinweispfeil 59). An einer zweiten Zeitlinie 60 ist der Versuch abgebrochen worden.

**Bezugszeichenliste**

| | | | |
|---|---|---|---|
| 1 | Anlagengehäuse | 36 | Kristallhubsteller |
| 2 | Schmelze | 37 | Tiegelhubsteller |
| 3 | Tiegel | 40 | PT1-Filter |
| 4 | Tiegelheizer | 41 | Regler |
| 5 | Kristall | 42 | Eingang |
| 6 | Kristallhubeinrichtung | 50 | Kurve |
| 7 | Tiegelhubeinrichtung | 51 | Kurve |
| 8 | Kamera | 52 | Kurve |
| 9 | Steuereinrichtung | 53 | Kurve |
| 10 | Hitzeschild | 54 | Zeitlinie |
| | | 55 | Hinweispfeil |
| 12 | Ringspalt | | |
| 13 | Kristallhubgeschwindigkeit | 56 | Hinweispfeil |
| 14 | Tiegelhubgeschwindigkeit | 57 | Hinweispfeil |
| | | 58 | Hinweispfeil |
| 20 | Durchmesserregler | 59 | Hinweispfeil |
| 21 | Eingang | 60 | Zeitlinie |
| 22 | Eingang | | |
| 23 | Ausgang | | |
| 24 | PT1-Filter | | |
| 25 | Ausgang | | |
| 26 | Regler | | |
| 27 | Eingang | | |
| 28 | Heizleistungssteller | | |
| 30 | Durchmesserregler | | |
| 31 | Eingang | | |
| 32 | Eingang | | |
| 33 | Ausgang | | |
| 34 | Ringspalthöhensteller | | |
| 35 | Ausgang | | |

## Patentansprüche

1. Verfahren zum Ziehen eines zylindrischen Kristalls (5) aus einer Schmelze (2) mittels einer Kristallziehanlage, die aufweist: Einen Tiegel (3), in dem sich die Schmelze (2) befindet, einen Tiegelheizer (4), der den Tiegel (3) ringförmig umgibt, eine Tiegelhubeinrichtung (7) zum Heben des Tiegels (3), eine Kristallhubeinrichtung (6) zum Ziehen des Kristalls (5) aus der Schmelze (2) und einen den Kristall (5) ringförmig umgebenden Hitzeschild (10), dessen untere Kante unter Bildung eines Ringspaltes (12) oberhalb der Schmelze (2) endet, **dadurch gekennzeichnet, dass** der Istwert des Kristalldurchmessers an der Schmelzenoberfläche gemessen und mit einem Sollwert für den Kristalldurchmesser verglichen wird,
dass die Höhe des Ringspaltes (12) in Abhängigkeit von der Abweichung zwischen dem Ist- und dem Sollwert mit einem ersten Regler, der eine erste Nachstellzeit aufweist, eingestellt wird, wobei bei einem Istwert, der kleiner ist als der Sollwert, die Ringspalthöhe verkleinert und bei einem Istwert, der größer ist als der Sollwert, die Ringspalthöhe vergrößert wird, und
dass zur Änderung der Ringspalthöhe die Hubgeschwindigkeit des Tiegels (3) und im gleichen Maße die Hubgeschwindigkeit des Kristalls (5) variiert werden, so dass die Kristallziehgeschwindigkeit konstant bleibt.

2. Verfahren nach Anspruch 1, **dadurch gekennzeichnet, dass** für die Hubgeschwindigkeit (14) des Tiegels ein Grundwert eingestellt wird, der den Volumenverbrauch der Schmelze (2) kompensiert, dass ein Grundwert für die Geschwindigkeit (13) des Kristallhubs eingestellt wird, und dass zur Regelung der Ringspalthöhe zu beiden Grundwerten der gleiche Offset-Wert hinzuaddiert wird.

3. Verfahren nach Anspruch 1 oder 2, **dadurch gekennzeichnet, dass** der Stellwert für die Ringspalthöhe als Istwert für eine Regelung der Heizleistung des Tiegelheizers (4) mittels eines zweiten Reglers, der eine zweite Nachstellzeit aufweist, zugeführt wird, wobei eine mittlere Ringspalthöhe als Sollwert vorgegeben wird.

4. Verfahren nach einem der vorhergehenden Ansprüche, **dadurch gekennzeichnet, dass** die erste Nachstellzeit kleiner ist als die zweite Nachstellzeit.

5. Verfahren nach Anspruch 3 oder 4, **dadurch gekennzeichnet, dass** der Stellwert für die Ringspalthöhe über einen PT1-Filter (40) einem Heizleistungssteller (28) als Istwert zugeführt wird.

## Claims

1. Method of pulling a cylindrical crystal (5) from a melt (2) by means of a crystal pulling system which has: a crucible (3) in which the melt (2) is located, a crucible heater (4) which surrounds the crucible (3) in an annular shape, a crucible lifting device (7) for lifting the crucible (3), a crystal lifting device (6) for drawing the crystal (5) from the melt (2) and a heat shield (10) which surrounds the crystal (5) in an annular shape and the lower edge of which (12) ends above the melt (2) and forms an annular gap, **characterized in that** the actual value of the crystal diameter is measured at the melt surface and compared with a setpoint value for the crystal diameter,
the height of the annular gap (12) is adjusted as a function of the deviation between the actual value and the setpoint value by means of a first controller which has a first reset time, the annular gap height being reduced in the case of an actual value which is smaller than the setpoint
value and the annular gap height being increased in the case of an actual value which is greater than the setpoint value, and
the lifting speed of the crucible (3) and, to the same extent, the lifting speed of the crystal (5) are varied in order to change the annular gap height, so that the crystal pulling speed remains constant.

2. Method according to claim 1, **characterized in that** a basic value is set for the lifting speed (14) of the crucible which compensates for the volume consumption of the melt (2), **in that** a basic value is set for the speed (13) of the crystal lifting, and that the same offset value is added to both basic values to regulate the annular gap height.

3. Method according to claim 1 or 2, **characterized in that** the setting value for the annular gap height is supplied as an actual value for regulating the heating power of the crucible heater (4) by means of a second regulator which has a second readjustment time, wherein an average annular gap height is specified as a setpoint value.

4. A method according to any one of the preceding claims, **characterized in that** the first reset time is less than the second reset time.

5. Method according to claim 3 or 4, **characterized in that** the setting value for the annular gap height is fed as an actual value to a heating power controller (28) via a PT1 filter (40).

## Revendications

1. Procédé de tirage d'un cristal cylindrique (5) à partir d'une masse fondue (2) au moyen d'une installation de tirage de cristaux, qui présente :
un creuset (3) dans lequel se trouve la masse fondue (2), un dispositif de chauffage du creuset (4) qui entoure le creuset (3) de manière annulaire, un dispositif de levage du creuset (7) pour soulever le creuset (3), un dispositif de levage du cristal (6) pour tirer le cristal (5) de la masse fondue (2) et un bouclier thermique (10) qui entoure le cristal (5) de manière annulaire et dont le bord inférieur se termine au-dessus de la masse fondue (2) et forme une fente annulaire (12),
(12), **caractérisé en ce que** la valeur réelle du diamètre des cristaux est mesurée à la surface de la masse fondue et est comparée à une valeur de consigne pour le diamètre des cristaux,
**en ce que** la hauteur de la fente annulaire (12) est réglée en fonction de l'écart entre la valeur réelle et la valeur de consigne avec un premier régulateur qui présente un premier temps de réglage, la hauteur de la fente annulaire étant réduite lorsque la valeur réelle est inférieure à la valeur de consigne et la hauteur de la fente annulaire étant augmentée lorsque la valeur réelle est supérieure à la valeur de consigne, et
**en ce que**, pour modifier la hauteur de la fente annulaire, on fait varier la vitesse de course du creuset (3) et, dans la même mesure, la vitesse de course du cristal (5), de sorte que la vitesse de tirage du cristal reste constante.

2. Procédé selon la revendication 1, **caractérisé en ce que** l'on règle une valeur de base pour la vitesse de levage (14) du creuset, qui compense la consommation de volume de la masse fondue (2), **en ce que** l'on règle une valeur de base pour la vitesse (13) de la course des cristaux et que, pour la régulation de la hauteur de la fente annulaire, la même valeur d'offset est ajoutée aux deux valeurs de base.

3. Procédé selon la revendication 1 ou 2, **caractérisé en ce que** la valeur de réglage pour la hauteur de la fente annulaire est amenée comme valeur réelle pour une régulation de la puissance du chauffage de creuset (4) au moyen d'un deuxième régulateur, qui présente un deuxième temps d'ajustage, dont une hauteur moyenne de la fente annulaire étant donnée comme valeur de consigne.

4. Procédé selon l'une des revendications précédentes, **caractérisé en ce que** le premier temps de réglage est inférieur au deuxième temps de réglage.

5. Procédé selon la revendication 3 ou 4, **caractérisé en ce que** la valeur de réglage pour la hauteur de la fente annulaire est amenée comme valeur réelle à un régulateur de puissance de chauffage (28) par l'intermédiaire d'un filtre PT1 (40).
